# EUROPEAN PATENT APPLICATION

(11) **EP 4 418 054 A1**
(43) Date of publication of application: **21.08.2024**
(21) Application number: 23163317.3
(22) Date of filing: 21.03.2023
(51) Int. Cl.: G04F 10/00

(54) **METHOD FOR CLOCKLESS AND DIRECT CONVERSION OF TIME INTERVAL TO DIGITAL WORD**

(30) Priority: 16.02.2023 PL 44380823
(71) Applicant: Akademia Gorniczo-Hutnicza im. Stanislawa Staszica w Krakowie, 30-059 Krakow (PL)
(72) Inventor: Koscielnik, Dariusz, 31-431 Kraków (PL); Jurasz, Konrad, 34-331 Swinna (PL); Szyduczynski, Jakub, 22-460 Szczebrzeszyn (PL)
(74) Representative: Wlasienko, Jozef

(57) **Abstract**

A method for clockless and direct conversion of a time interval to a digital word is characterized in that the converted time interval (T) is mapped in the form of a difference between a reference time period (RT) and a signal time period (ST), a sum of lengths of which is approximately proportional to the length of the converted time interval (T). The reference time period (RT) is first measured roughly using linear method, and next precisely by method of weight compensation.

## Description

The subject of the invention is a method for clockless and direct conversion of a time interval to a digital word that can be applied in monitoring and control systems that require very high energy efficiency, such as biomedical equipment and mobile devices.

From the publication: Konrad Jurasz, Dariusz Kościelnik, Jakub Szyduczyński, Marek Miśkowicz, entitled "Systematization and comparison of the binary successive approximation variants", Sensors 2021, 21(24), 8267, three different variants of the analog-to-digital conversion by successive approximation method (weight compensation) are known. One of these algorithms called Monotonic Successive Approximation (MSA) allows direct conversion of non-decrementable physical quantities and simultaneously is characterized by good energy efficiency. The implementation of the MSA algorithm never requires undoing previously made decisions, even if they lead to a temporary overestimation of a measurement result. As a result, the MSA algorithm allows direct conversion of time intervals that are non-decrementable by nature. A characteristic feature of the MSA algorithm is also the fact that all binary scaled reference elements are each time used in the conversion process, as well as the associated constant energy expenditure, regardless of the size of a measured object.

A method for direct conversion of a the time interval to a digital word is known from the patent specification US 9612581 B1. This method uses the MSA algorithm, by mapping the converted time interval in the form of a difference of lengths of a reference time period and of a signal time period. The reference time period is measured from a time instant when a beginning of the converted time interval is detected, whereas the signal time period is measured from a time instant when an end of the converted time interval is detected. The measurement of both time periods is terminated at the same time instant, after using all available reference elements. These reference elements are quantized, binary scaled reference intervals having known lengths. The reference time period is composed of reference intervals obtained as times of charging, by means of a reference current source, capacitors selected from of a set of n binary scaled capacitors, wherein n is the number of bits of the output digital word. Capacitance of each subsequent capacitor in the set is twice as low as the capacitance of its immediately preceding capacitor. From the set of capacitors that capacitor is always selected, whose capacitance is currently the highest among capacitors that have not been charged yet. Voltage building up across the charged capacitor is controlled by means of a reference comparator. The process of charging the capacitor, and therefore measuring the quantized reference interval is terminated at a time instant when the voltage building up between plates of the charged capacitor reaches a value of threshold voltage. Then another, correspondingly shorter reference interval is started to be measured. To this end, from the set of capacitors a capacitor is selected, whose capacitance is currently the highest among capacitors that have not been charged yet.

The signal time period is composed in a similar manner. Capacitors selected from the same set of capacitors are charged by means of the signal current source, and voltage building up across them is controlled by means of a signal comparator. From the set of capacitors always that capacitor is selected, whose capacitance is currently the highest among capacitors that have not been charged yet.

To each capacitor of given index and belonging to the used set of capacitors a bit having the same index is assigned and included in the output digital word. If during charging a given capacitor by means of the reference current source charging of the next capacitor by means of the signal current source is not started, or, if during charging a given capacitor by means of the signal current source charging of the next capacitor by means of the reference current source is started, then to the bit assigned to this capacitor a value one is assigned. In other cases, a value zero is assigned to this bit.

Regardless of the length of the converted time interval, the end result of the conversion process is charging all capacitors of the used set of capacitors to threshold voltage. The amount of charge, and therefore energy, taken for this purpose from a power source is therefore always the same. The total length of the reference time period and of the signal time period is also constant and independent of the length of the converted time interval. Conversion time redundancy beyond the length of the converted time interval, on the other hand, is the larger the shorter the converted interval.

The task of the invention is to provide a method for clockless and direct conversion of a time interval to a digital word, destined for using in control and monitoring systems with high energy efficiency.

According to the invention, a method for clockless and direct conversion of a time interval to a digital word consists in detecting a beginning and an end of the converted time interval by means of a control module, and mapping the converted time interval in the form of a difference of lengths of a reference time period and of a signal time period. The reference time period is measured from a time instant when the beginning of the converted time interval is detected by means of the control module. The signal time period is measured from a time instant when the end of the converted time interval is detected by means of the control module. The measurement of both time periods is terminated at the same time instant. A precise measurement of a final fragment of the reference time period and of the whole signal time period is implemented by method of weight compensation, in a known way. The final fragment of the reference time period is composed of quantized, binary scaled reference intervals having known lengths, which are measured by charging, by means of a reference current source, capacitors selected from a set of capacitors by means of the control module. Capacitance of each subsequent capacitor in the set of capacitors is twice as low as the capacitance of its immediately preceding capacitor. From the set of capacitors always that capacitor is selected by means of the control module, whose capacitance is currently the highest among capacitors that have not been charged yet. The selected capacitor is charged until reference voltage building up across it, which is compared with threshold voltage by means of a reference comparator, is equal to the threshold voltage. A measurement of another reference interval is then started by charging another capacitor by means of the reference current source. This capacitor is selected from the set of capacitors by means of the control module.

The signal time period is composed of quantized, binary scaled reference intervals having known lengths, which are measured by charging, by means of the signal current source, capacitors selected from the set of capacitors by means of the control module. From the set of capacitors always that capacitor is selected by means of the control module, whose capacitance is currently the highest among capacitors that have not been charged yet. The selected capacitor is charged until signal voltage building up across it, which is compared with threshold voltage by the signal comparator, is equal to the threshold voltage. A measurement of another reference interval is then started by charging another capacitor by means of the signal current source. This capacitor is selected from the set of capacitors by means of the control module.

Simultaneously with composing the reference time period and composing the signal time period, the control module assigns, in a known way, corresponding logical values to successive ones from among n-r least significant bits of the output digital word, where n is the number of bits of the output digital word, and r is a linearization degree. To a bit of given index and belonging to n-r least significant bits of the output digital word, a value one is assigned by means of the control module, if during charging a capacitor having the same index and belonging to the set of capacitors by means of the reference current source, charging of the next capacitor by means of the signal current source is not started. To a bit of given index and belonging to n-r least significant bits of the output digital word, a value one is assigned by means of the control module also when during charging a capacitor having the same index and belonging to the set of capacitors by means of the signal current source, charging of the next capacitor by means of the reference current source is started. In other cases, a value zero is assigned to such bit by means of the control module.

The mentioned actions related to composing the final fragment of the reference time period, composing the whole signal time period, and assigning the corresponding logical values to n-r least significant bits of the output digital word are repeated until all capacitors from the set of capacitors are used. The measurement of the reference time period and of the signal time period is then terminated.

The essence of the invention is that a sum of the lengths of the reference time period and of the signal time period is approximately proportional to the length of the converted time interval. The length of the reference time period is first roughly determined by measuring an initial fragment of the reference time period using linear method. The initial fragment of the reference time period is composed of counter intervals of identical length which is twice the length of the longest one from the binary scaled reference intervals. The composing counter intervals are counted by means of an r-bit counter. This counter is first reset by means of the control module at the time instant when the beginning of the converted time interval is detected by means of the control module. The counter intervals are measured by charging one counter capacitor by means of the reference current source, wherein capacitance of each counter capacitor is the same. The counter capacitor is charged until reference voltage building up across it, which is compared with threshold voltage by means of the reference comparator, is equal to the threshold voltage. This counter capacitor is then discharged by means of its assigned counter switch, by short-circuiting plates of the counter capacitor.

If no end of the converted time interval is detected during the measurement of a given counter interval by means of the control module, then the content of the counter is incremented by means of the control module. Next, new content of the counter is checked by means of the control module. If any of bits of this counter has a value zero, then another counter interval is measured by charging a counter capacitor other than before by means of the reference current source. These actions are repeated until the end of the measurement of the counter interval, during which the end of the converted time interval is detected by means of the control module, or it is checked by means of the control module that after incrementing the counter by means of the control module new content of the counter consists only of bits with a value one. Then, in both cases, to r most significant bits of the output digital word values of r bits of the counter are assigned by means of the control module. At the same time, a measurement of the final fragment of the reference time period is started in a known way.

It is advantageous if the linearization degree r is a natural number greater than one and less than the number n of bits of the output digital word.

It is advantageous if efficiency of the reference current source is the same as efficiency of the signal current source and simultaneously capacitance of each counter capacitor is twice as high as capacitance of the capacitor with the highest capacitance in the set of capacitors.

It is also advantageous if efficiency of the reference current source is controlled. During measuring the initial fragment of the reference time period the efficiency of the reference current source is kept by means of the control module at a value k-times lower than the efficiency of the signal current source. On the other hand, during measuring the final fragment of the reference time period the efficiency of the reference current source is kept by means of the control module at a value equal to the efficiency of the signal current source. At the same time capacitance of each counter capacitor is k-times lower than double capacitance of the capacitor with the highest capacitance in the set of capacitors.

The advantage of the solution consists in maintaining a self-clocking capability of the entire conversion process, which does not require the use of an energy-intensive clock signal source. High energy efficiency of the solution is also due to the suspension of all activities in intervals between successive conversion processes.

As a result of using an initial, rough conversion using linear method and repeated using the same two counter capacitors, the number of necessary of capacitors has been reduced. From among capacitors used in the known solution that uses conversion solely by method of weight compensation, those with the largest capacitances accumulating the greatest amount of electric charge drawn from a power source have become redundant. For the linearization coefficient r = 2, 3, 4 the total capacitance of necessary capacitors is reduced by 25 %, 62.5 %, 81.25 %, respectively. The amount of energy drawn from a power source and associated with filling the capacitors is thus also reduced. For the linearization coefficient r = 2, 3, 4 its average value is decreased by 28.75%, 32.81%, 41.02%, respectively.

Average processing time for the linearization coefficient r = 2, 3, 4, is decreased relative to the known solution by 12,5 %, 21,87 %, 27,34 % respectively. Processing time redundancy is reduced to an even greater extent beyond the length of the measured time interval. For the linearization coefficient r = 2, 3, 4 its average value is decreased by 37.5 %, 65.62 %, 82.03 %, respectively.

Further increasing the value of the linearization coefficient r improves all the mentioned parameters, but at the same time it leads to an increase in the number of processing steps and the resulting dynamic energy consumption. The average number of system state switchovers, which in the known solution is always n+1, for the linearization coefficient r = 2, 3, 4 is increased by 0.25, 1.375, 4.438, respectively.

The use of the reference current source with reduced efficiency allows for multiple capacitance reduction of both counter capacitors, which otherwise constitutes more than two-thirds of the total capacitance of all necessary capacitors. The amount of area and energy required by the counter capacitors decreases proportionally to temporary efficiency reduction of the reference current source.

The subject of the invention is explained in embodiments in the drawing presenting:
- Fig. 1 -: an apparatus in idle state awaiting a beginning of a converted time interval,
- Fig. 2 -: mutual relationships between a reference time period RT and a signal time period ST for a converted time interval of a length that does not use full capacity of a counter Ct.
- Fig. 3 -: mutual relationships between a reference time period RT and a signal time period ST for a converted time interval of a length that uses full capacity of a 3-bit counter Ct.

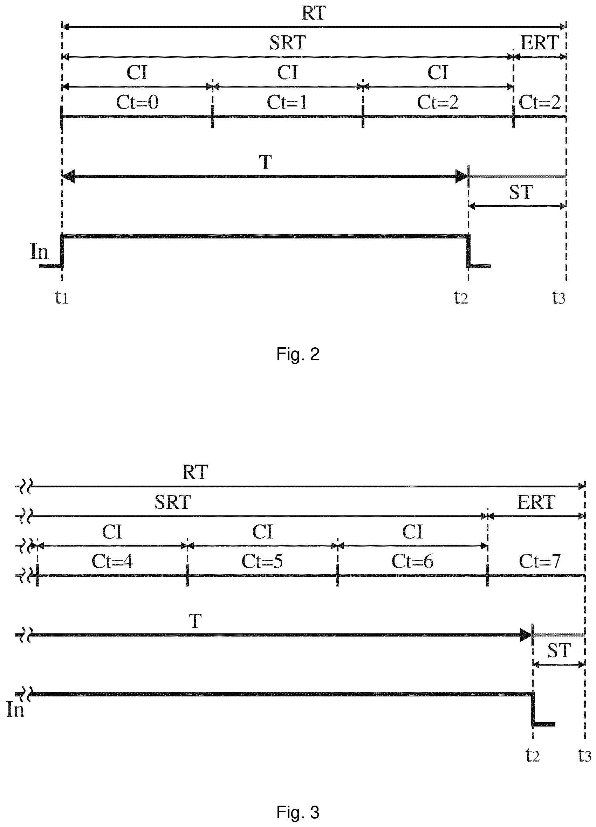

According to the invention a method for clockless and direct conversion of a time interval to a digital word consists in determining a difference of lengths of a reference time period RT and of a signal time period ST, mapping a length of the converted time interval T (Fig. 2 and Fig. 3). Measuring the reference time period RT is started at a time instant t₁ when the beginning of the converted time interval T is detected by means of a control module CM (Fig. 2). An initial fragment SRT of the reference time period RT is roughly measured using linear method, whereas a final fragment ERT of the reference time period RT is precisely measured by method of weight compensation. Measuring the signal time period ST is started at a time instant t₂ when the end of the converted time interval T is detected by means of the control module CM (Fig. 2 and Fig. 3). The whole signal time period ST is precisely measured by method of weight compensation. The measurement of both time periods is terminated at the same time instant t₃ (Fig. 2 and Fig. 3), after exhaustion of the common set of n-r quantized, binary scaled reference intervals having known lengths, used to compose the final fragment ERT of the reference time period RT and the whole signal time period ST. Here, the parameter r is the linearization degree, whose most preferred values are: 2, 3 or 4, whereas n is the number of bits bₙ₋₁, ..., bₙ₋ᵣ, bₙ₋ᵣ₋₁, ..., b₀ of the output digital word B, comprising r most significant bits bₙ₋₁, ..., bₙ₋ᵣ and n-r least significant bits bₙ₋ᵣ₋₁, ..., b₀. To this word a value of the length difference of the reference time period RT and of the signal time period ST is assigned by means of the control module CM, which value has a binary form and represents the final result of the conversion process.

A sum of the lengths of the reference time period RT and of the signal time period ST is approximately proportional to the length of the converted time interval T (Fig. 2 and Fig. 3). The length of the reference time period RT is first roughly determined by measuring the initial fragment SRT of the reference time period RT using linear method. The initial fragment SRT of the reference time period RT is composed of counter intervals CI. All counter intervals CI have identical length (Fig. 2 and Fig. 3), which is twice as high as the length of the longest one from the binary scaled reference intervals. The measured counter intervals CI are counted by means of an r-bit counter Ct, wherein the counter Ct is first reset by means of the control module CM at the time instant t₁ when the beginning of the converted time interval T is detected by means of the control module CM. Each counter interval CI is measured by charging one of two counter capacitors Cₙ₋ᵣ by means of a reference current source I_{R}. In this exemplary solution, efficiency of the reference current source I_{R} is equal to efficiency of a signal current source Is, and capacitance of each counter capacitor Cₙ₋ᵣ is the same and simultaneously is twice as high as capacitance of the capacitor Cₙ₋ᵣ₋₁ with the highest capacitance in a set of capacitors CS. The counter capacitor Cₙ₋ᵣ is charged until reference voltage U_{R} building up across it, which is compared with threshold voltage U_{TH} by means of a reference comparator K_{R}, is equal to the threshold voltage U_{TH}. The charged counter capacitor Cₙ₋ᵣ is then discharged by means of a counter switch Sₙ₋ᵣ, by short-circuiting plates of the counter capacitor Cₙ₋ᵣ.

If no end of the converted time interval T is detected during the measurement of a given counter interval CI by means of the control module, then the content of the counter Ct is incremented by means of the control module CM (Fig. 2 and Fig. 3). Next, new content of the counter Ct is checked by means of the control module CM. If any of bits of this counter has a value zero, then another counter interval CI is measured by charging a counter capacitor Cₙ₋ᵣ other than before by means of the reference current source I_{R} (Fig. 2 and Fig. 3). These actions are repeated until the end of measuring the counter interval Cl, during which the end of the converted time interval T is detected by means of the control module CM (Fig. 2), or it is checked by means of the control module CM that after incrementing the counter Ct by means of the control module CM new content of the counter Ct consists only of bits with a value one.

In both mentioned cases, to r most significant bits bₙ₋₁, ..., bₙ₋ᵣ of the output digital word B values of r bits of the counter Ct are assigned by means of the control module CM. At the same time, measuring, in a known way, of the final fragment ERT of the reference time period RT is started by method of weight compensation. The final fragment ERT of the reference time period RT is composed of quantized, binary scaled reference intervals having known lengths. These intervals are measured by charging, by means of the reference current source I_{R}, capacitors selected from the set of capacitors CS by means of the control module CM. Capacitance of each subsequent capacitor Cₙ₋ᵣ₋₁, ..., C₀ in the set of capacitors CS is twice as low as the capacitance of its immediately preceding capacitor. From the set of capacitors CS always that capacitor is selected by means of the control module CM, whose capacitance is currently the highest among capacitors Cₙ₋ᵣ₋₁, ..., C₀ of this set, that have not been charged yet. The selected capacitor is charged until reference voltage U_{R} building up across it, which is compared with threshold voltage U_{TH} by means of the reference comparator K_{R}, is equal to the threshold voltage U_{TH}. A measurement of another reference interval is then started by charging, by means of the reference current source I_{R}, another capacitor that is selected from the set of capacitors CS by means of the control module CM. These actions are repeated until the set of capacitors Cₙ₋ᵣ₋₁, ..., C₀ from the set of capacitors CS is exhausted.

The signal time period ST is composed of quantized, binary scaled reference intervals having known lengths, which are measured by charging, by means of the signal current source Is, capacitors selected from the set of capacitors CS by means of the control module CM. From the set of capacitors CS always that capacitor is selected by means of the control module CM, whose capacitance is currently the highest among capacitors Cₙ₋ᵣ₋₁, ..., C₀ of this set that have not been charged yet. The selected capacitor is charged until signal voltage Us building up across it, which is compared with threshold voltage U_{TH} by the signal comparator Ks, is equal to the threshold voltage U_{TH}. A measurement of another reference interval is then started by charging, by means of the signal current source Is, another capacitor which is selected from the set of capacitors CS by means of the control module CM. These actions are repeated until the set of capacitors Cₙ₋ᵣ₋₁, ..., C₀ from the set of capacitors CS is exhausted.

Simultaneously with measuring the final fragment ERT of the reference time period RT and measuring the whole signal time period ST the control module assigns, in a known way, corresponding logical values to successive ones from among n-r least significant bits bₙ₋ᵣ₋₁, ..., b₀ of the output digital word B. To a bit bₓ of given index x and belonging to n-r least significant bits bₙ₋ᵣ₋₁, ..., b₀ of the output digital word B, a value one is assigned by means of the control module CM, if during charging a capacitor Cₓ having the same index x and belonging to the set of capacitors CS by means of the reference current source I_{R}, charging of the next capacitor by means of the signal current source I_{S} is not started. To a bit b_{y} of index y a value one is assigned by means of the control module CM, if during charging a capacitor C_{y} having the same index y and belonging to the set of capacitors CS by means of the signal current source Is, charging of the next capacitor by means of the reference current source I_{R} is started. In other cases, to a bit belonging to n-r least significant bits bₙ₋ᵣ₋₁, ..., b₀ of the output digital word B a value zero is assigned by means of the control module CM.

The mentioned actions related to measuring the final fragment ERT of the reference time period RT, measuring the whole signal time period ST and assigning the corresponding logical values to n-r least significant bits bₙ₋ᵣ₋₁, ..., b₀ of the output digital word B are repeated until such time, when during charging the capacitor C₀ with the lowest capacitance in the set CS it is detected by means of the control module CM, either that the reference voltage U_{R} building up across the capacitor charged by the reference current source I_{R} and controlled by means of the reference comparator K_{R}, or the signal voltage Us building up across the capacitor charged by the signal current source Is and controlled by means of the signal comparator Ks is equal to the threshold voltage U_{TH}.

Another method for clockless and direct conversion of a time interval to a digital word, according to the invention, differs from the previous one in that during measuring the initial fragment SRT of the reference time period RT efficiency of the reference current source I_{R} is kept by means of the control module CM at a value 5 times lower than the efficiency of the signal current source Is. During measuring of the final fragment ERT of the reference time period RT efficiency of the reference current source I_{R} is, on the other hand, kept by means of the control module CM at a value equal to the efficiency of the signal current source Is. Furthermore, capacitance of each counter capacitor Cₙ₋ᵣ is the same and simultaneously five times lower than double capacitance of the capacitor Cₙ₋ᵣ₋₁ with the highest capacitance in the set of capacitors CS.

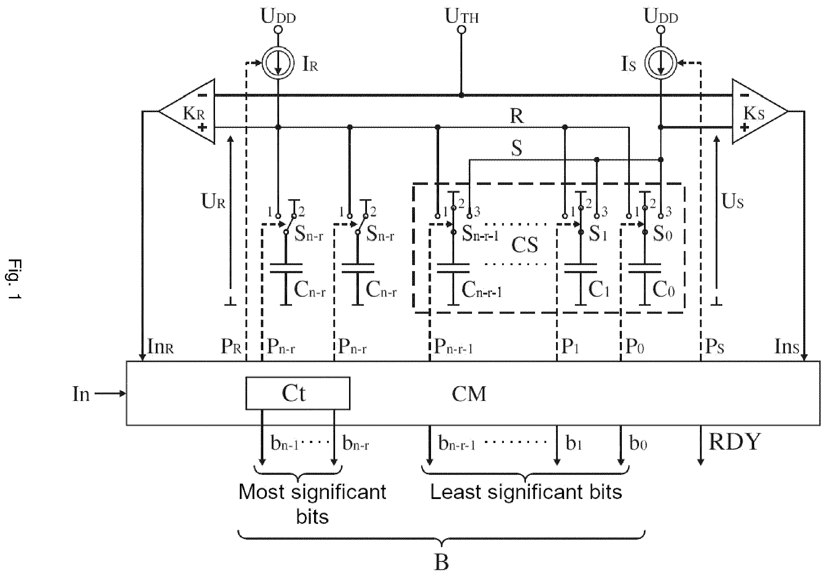

An apparatus for clockless and direct conversion of a time interval to a digital word, in a first exemplary solution (Fig. 1), comprises a control module CM equipped with a converted time interval input In, a complete conversion output RDY, a reference input In_{R} and a signal input Ins. The control module CM is furthermore equipped with a reference output P_{R}, a signal output Ps, control outputs Pₙ₋ᵣ₋₁, ..., P₀, two counter outputs Pₙ₋ᵣ and an output of n-bit output digital word B. The output digital word B comprises r most significant bits bₙ₋₁, ..., bᵣ and n-r least significant bits bₙ₋ᵣ₋₁, ..., b₀. The parameter r is a linearization degree, and its most advantageous values are: 2, 3 or 4. The control module CM comprises also an r-bit counter Ct, whose outputs are connected to outputs of r most significant bits bₙ₋₁, ..., bₙ₋ᵣ of the output digital word B.

The reference input In_{R} of the control module CM is connected to an output of a reference comparator K_{R}, and the signal input Ins of the control module CM is connected to an output of a signal comparator Ks. The reference output P_{R} of the control module CM is connected to a control input of a reference current source I_{R}, and the signal output Ps of the control module CM is connected to a control input of a signal current source Is. In this exemplary apparatus, efficiency of the reference current source I_{R} is the same as efficiency of the signal current source Is. The control outputs Pₙ₋ᵣ₋₁, ..., P₀ of the control module CM are connected, respectively, to control inputs of switches of a set Sₙ₋ᵣ₋₁, ..., S₀. Each counter output Pₙ₋ᵣ of the control module CM is connected to a control input of a different one of two counter switches Sₙ₋ᵣ.

A non-inverting input of the reference comparator K_{R} is connected to a reference bus R and to an output of the reference current source I_{R}, whose input is connected to supply voltage U_{DD}. An inverting input of the reference comparator K_{R} is connected to threshold voltage U_{TH}. A non-inverting input of the signal comparator Ks is connected to a signal bus S and to an output of the signal current source Is, whose input is connected to the supply voltage U_{DD}. An inverting input of the signal comparator Ks is connected to the threshold voltage U_{TH} and to the inverting input of the reference comparator K_{R}.

A set of capacitors CS comprises n-r capacitors Cₙ₋ᵣ₋₁, ..., C₀, and capacitance of each subsequent capacitor Cₙ₋ᵣ₋₁, ..., C₀ of the set of capacitors CS is twice as low as the capacitance of its immediately preceding capacitor. A bottom plate of each capacitor Cₙ₋ᵣ₋₁, ..., C₀ of the set of capacitors CS is connected to a ground of the circuit. In this exemplary apparatus, capacitance of each of two counter capacitors Cₙ₋ᵣ is the same and simultaneously is twice as high as capacitance of the capacitor Cₙ₋ᵣ₋₁ with the highest capacitance in the set of capacitors CS. A bottom plate of each of two counter capacitors Cₙ₋ᵣ is connected to the ground of the circuit.

A top plate of each capacitor Cₙ₋ᵣ₋₁, ..., C₀ of the set of capacitors CS is connected, respectively, to a moving contact of a switch of the set Sₙ₋ᵣ₋₁, ..., S₀. A first stationary contact of each switch of the set Sₙ₋ᵣ₋₁, ..., S₀ is connected to the reference bus R. A second stationary contact of each switch of the set Sₙ₋ᵣ₋₁, ..., S₀ is connected to the ground of the circuit. A third stationary contact of each switch of the set Sₙ₋ᵣ₋₁, ..., S₀ is, in turn, connected to the signal bus S.

A top plate of each of two counter capacitors Cₙ₋ᵣ is connected to a moving contact of a different one of the two counter switches Sₙ₋ᵣ. A first stationary contact of each counter switch Sₙ₋ᵣ is connected to the reference bus R. A second stationary contact of each counter switch Sₙ₋ᵣ is, in turn, connected to the ground of the circuit.

An apparatus for clockless and direct conversion of a time interval to a digital word, in a second exemplary solution, differs from the first one in that efficiency of the reference current source I_{R} is controlled and kept by means of the control module CM at a value 5 times lower than efficiency of the signal current source Is or equal to the efficiency of the signal current source Is. Furthermore, capacitance of each counter capacitor Cₙ₋ᵣ is the same and simultaneously five times lower than double capacitance of the capacitor Cₙ₋ᵣ₋₁ with the highest capacitance in the set of capacitors CS.

In the following description of the conversion process, below notation has been adopted:
x is an index of a capacitor Cₓ from the set of capacitors CS, currently charged by the reference current source I_{R},
y is an index of a capacitor C_{y} from the set of capacitors CS, currently charged by the signal current source Is,
z is an index of a capacitor C_{z}, whose capacitance is currently the highest among those capacitors from the set of capacitors CS that have not been charged yet.

A clockless and direct conversion of a time interval to a digital word, implemented according to the invention in a first exemplary apparatus (Fig. 1), proceeds as follows. Before the conversion process is started, the control module CM causes, by means of a signal from the reference output P_{R}, switching off the reference current source I_{R}, whereas by means of a signal from the signal output Ps the control module CM causes switching off the signal current source Is. By means of signals from the control outputs Pₙ₋ᵣ₋₁, ..., P₀ the control module CM causes switching the switches of the set Sₙ₋ᵣ₋₁, ..., S₀ to second positions, and therefore connecting top plates of all capacitors Cₙ₋ᵣ₋₁, ..., C₀ of the set of capacitors CS to the ground of the circuit, forcing a complete discharge of all capacitors Cₙ₋ᵣ₋₁, ..., C₀ of the set of capacitors CS. By means of signals from both counter outputs Pₙ₋ᵣ the control module CM causes switching both counter switches Sₙ₋ᵣ to second position, and therefore connecting top plates of both counter capacitors Cₙ₋ᵣ to the ground of the circuit, forcing a complete discharge of both counter capacitors Cₙ₋ᵣ. Next, the control module CM starts to monitor the state of a converted time interval input In in order to detect a beginning of the converted time interval T.

At the time instant t₁ when the beginning of the converted time interval T is detected by the control module CM, signaled at the converted time interval input In, the control module CM starts to monitor the state of the converted time interval input In in order to detect an end of the converted time interval T. At the same time, the control module CM puts a complete conversion output RDY in inactive state and resets the state of the counter Ct. Next, the control module CM starts to roughly measure an initial fragment SRT of the reference time period RT using linear method (Fig. 2). First, the control module CM selects any of two counter capacitors Cₙ₋ᵣ and a counter switch Sₙ₋ᵣ and a counter output Pₙ₋ᵣ assigned to the selected counter capacitor Cₙ₋ᵣ. Next, the control module CM causes, by means of a signal from the selected counter output Pₙ₋ᵣ, switching the selected counter switch Sₙ₋ᵣ to first position, and therefore connecting a top plate of the selected counter capacitor Cₙ₋ᵣ to the output of the reference current source I_{R}. At the same time, by means of a signal from the reference output P_{R}, the control module CM causes switching on the reference current source I_{R}. The control module CM starts to measure a counter interval CI (Fig. 2). Reference voltage U_{R} building up across the selected counter capacitor Cₙ₋ᵣ, charged by the reference current source I_{R}, is compared by means of the reference comparator K_{R} with the threshold voltage U_{TH}. When the reference voltage U_{R} reaches the threshold voltage U_{TH}, then, based on the output signal of the reference comparator K_{R}, the control module CM terminates measuring the counter interval CI. To this end, the control module CM causes, by means of a signal from the selected counter output Pₙ₋ᵣ, switching the selected counter switch Sₙ₋ᵣ to second position, and therefore disconnecting the top plate of the selected counter capacitor Cₙ₋ᵣ from the output of the reference current source I_{R} and at the same time connecting the top plate of the selected counter capacitor Cₙ₋ᵣ to the ground of the circuit, forcing a complete discharge of this capacitor.

If the control module does not detect the end of the converted time interval T during measuring the counter interval Cl, then the control module CM increments the content of the counter Ct (Fig. 2 and Fig. 3). Next, the control module CM checks new content of the counter Ct. If any of bits of this counter is zero, meaning that the counter has not reached its maximum value, then the control module CM starts to measure another counter interval CI (Fig. 2). To this end, the control module CM selects a different one of the counter capacitors Cₙ₋ᵣ than the one charged immediately before and a counter switch Sₙ₋ᵣ and a counter output Pₙ₋ᵣ assigned to this counter capacitor Cₙ₋ᵣ. By means of a signal from the selected counter output Pₙ₋ᵣ the control module CM causes switching the selected counter switch Sₙ₋ᵣ to first position, and therefore connecting a top plate of the selected counter capacitor Cₙ₋ᵣ to the output of the reference current source I_{R} and thus starting charging the selected counter capacitor Cₙ₋ᵣ. The control module CM repeats actions related to measuring the counter intervals CI until the end of measuring the counter interval Cl, during which the control module CM detects the end of the converted time interval T (Fig. 2), or when after incrementing the value of the counter Ct the control module CM checks that new content of the counter Ct consists only of bits with a value one (Fig. 3).

In both mentioned cases, to r most significant bits bₙ₋₁, ..., bₙ₋ᵣ of the output digital word B the control module CM assigns a final value by means of the outputs of the r-bit counter Ct. At the same time, the control module starts a precise measurement of a final fragment ERT of the reference time period RT by method of weight compensation (Fig. 2 and Fig. 3). First, the control module CM selects from the set of capacitors CS a capacitor C_{z}, whose capacitance is currently the highest among those capacitors Cₙ₋ᵣ₋₁, ..., C₀ of the set of capacitors CS that have not been charged yet. Next, the control module CM causes, by means of a signal from a control output P_{z}, switching a switch of a set S_{z} to first position, and therefore connecting a top plate of the capacitor C_{z} to the output of the reference current source I_{R}. The control module CM starts to measure the reference interval. The reference voltage U_{R} building up across the capacitor Cₓ, charged by the reference current source I_{R}, is compared by means of the reference comparator K_{R} with the threshold voltage U_{TH}. When the reference voltage U_{R} reaches the threshold voltage U_{TH}, then, based on the output signal of the reference comparator K_{R}, the control module CM terminates measuring the reference interval. To this end, the control module CM causes, by means of a signal from the control output Pₓ, switching a switch of a set Sₓ to second position, and therefore disconnecting a top plate of the capacitor Cₓ from the output of the reference current source I_{R} and at the same time connecting the top plate of the capacitor Cₓ to the ground of the circuit, forcing a complete discharge of this capacitor. At the same time, the control module CM assigns a value one to a bit bₓ, if during charging the capacitor Cₓ by means of the reference current source I_{R}, charging of the next capacitor is not started by means of the signal current source Is. Otherwise the control module CM assigns a value zero to the bit bₓ. At the same time, the control module CM starts to measure another reference interval. To this end, the control module CM selects from the set of capacitors CS a capacitor C_{z}, whose capacitance is currently the highest among those capacitors Cₙ₋ᵣ₋₁, ..., C₀ of the set of capacitors CS that have not been charged yet. Next, the control module CM causes, by means of a signal from the control output P_{z}, switching a switch of the set S_{z} to first position, and therefore connecting the top plate of the capacitor C_{z} to the output of the reference current source I_{R} and thus starting charging this capacitor. These actions are repeated until the time instant t₃ of the reference time period RT measuring end.

At the time instant t₂ when the end of the converted time interval T is detected by the control module CM, signaled at the converted time interval input In, the control module CM starts a precise measurement of a signal time period ST by method of weight compensation (Fig. 2 and Fig. 3). First, the control module CM selects from the set of capacitors CS a capacitor C_{z}, whose capacitance is currently the highest among those capacitors Cₙ₋ᵣ₋₁, ..., C₀ of the set of capacitors CS that have not been charged yet. Next, the control module CM causes, by means of a signal from the control output P_{z}, switching a switch of the set S_{z} to third position, and therefore connecting the top plate of the capacitor C_{z} to an output of the signal current source Is. At the same time, by means of a signal from the signal output Ps, the control module CM causes turning on the signal current source Is. The control module CM starts to measure the reference interval. Signal voltage Us building up across the capacitor C_{y}, charged by the signal current source Is, is compared by the signal comparator Ks with the threshold voltage U_{TH}. When the signal voltage Us reaches the threshold voltage U_{TH}, then, based on the output signal of the signal comparator Ks, the control module CM terminates measuring the reference interval. To this end, the control module CM causes, by means of a signal from the control output P_{y}, switching a switch of a set S_{y} to second position, and therefore disconnecting a top plate of the capacitor C_{y} from the output of the signal current source Is and at the same time connecting the top plate of the capacitor C_{y} to the ground of the circuit, forcing a complete discharge of this capacitor. At the same time, the control module CM assigns a value one to a bit b_{y}, if, during charging the capacitor C_{y} by means of the signal current source Is, charging of another capacitor is started by means of the reference current source I_{R}. Otherwise the control module CM assigns a value zero to the bit b_{y}. At the same time, the control module CM starts to measure another reference interval. To this end, the control module CM selects from the set of capacitors CS a capacitor C_{z}, whose capacitance is currently the highest among those capacitors Cₙ₋ᵣ₋₁, ..., C₀ of the set of capacitors CS that have not been charged yet]. Next, the control module CM causes, by means of a signal from the control output P_{z}, switching a switch of the set S_{z} to third position, and therefore connecting the top plate of the capacitor C_{z} to the output of the signal current source Is and thus starting charging this capacitor. These actions are repeated until the time instant t₃ of the end of measuring the signal time period ST.

Measuring the reference time period RT and the signal time period ST is terminated by the control module CM at the time instant t₃ (Fig. 2 and Fig. 3), when during charging the capacitor C₀ with the lowest capacitance in the set of capacitors CS the control module CM detects either that the reference voltage U_{R} building up across the capacitor Cₓ charged by the reference current source I_{R} is equal to the threshold voltage U_{TH} based on the output signal of the reference comparator K_{R}, or that the signal voltage Us building up across the capacitor C_{y} charged by the signal current source Is is equal to the threshold voltage U_{TH} based on the output signal of the signal comparator Ks. The control module CM causes then, by means of a signal from the reference output P_{R}, switching off the reference current source I_{R} and simultaneously by means of a signal from the signal output Ps the control module CM causes switching off the signal current source Is. By means of signals from the control outputs Pₙ₋ᵣ₋₁, ..., P₀ the control module CM causes switching the switches of the set Sₙ₋ᵣ₋₁, ..., S₀ to second positions, and therefore connecting the top plates of all capacitors Cₙ₋ᵣ₋₁, ..., C₀ of the set of capacitors CS to the ground of the circuit, forcing a complete discharge of all capacitors Cₙ₋ᵣ₋₁, ..., C₀ of the set of capacitors CS. At the same time, the control module CM causes switching both counter switches Sₙ₋ᵣ to second position, and therefore connecting the top plates of both counter capacitors Cₙ₋ᵣ to the ground of the circuit, forcing a complete discharge of both counter capacitors Cₙ₋ᵣ. Next, the control module CM puts the complete conversion output RDY in active state. At the same time, the control module CM starts to monitor the state of the converted time interval input In in order to detect a beginning of the next converted time interval T.

A clockless and direct conversion of a time interval to a digital word, implemented according to the invention in a second exemplary apparatus, differs from the one implemented_in the first exemplary apparatus in that during measuring the initial fragment SRT of the reference time period RT the control module CM keeps, by means of a signal from the reference output P_{R}, the efficiency of the reference current source I_{R} at a value 5 times lower than the efficiency of the signal current source Is. On the other hand, during measuring the final fragment ERT of the reference time period RT the control module CM keeps, by means of a signal from the reference output P_{R}, the efficiency of the reference current source I_{R} at a value equal to the efficiency of the signal current source Is.

### List of references in the drawing

- In: converted time interval input
- Ins: signal input
- In_{R}: reference input
- Ps: signal output
- P_{R}: reference output
- B: digital word output
- bₙ₋₁, ..., bᵣ: most significant bits of the output digital word
- bₙ₋ᵣ₋₁, ..., b₀: least significant bits of the output digital word
- RDY: complete conversion output
- Is: signal current source
- I_{R}: reference current source
- S: signal bus
- R: reference bus
- Ks: signal comparator
- K_{R}: reference comparator
- CS: set of capacitors
- Cₙ₋ᵣ₋₁, ..., C₀: capacitors of the capacitor set
- Cₙ₋ᵣ₋₁: capacitor having the highest capacitance in the set of capacitors
- C₀: capacitor having the lowest capacitance in the set of capacitors
- Cₙ₋ᵣ: counter capacitor
- Sₙ₋ᵣ₋₁, ..., S₀: switches of the set
- Sₙ₋ᵣ: counter switch
- Pₙ₋ᵣ₋₁, ..., P₀: control outputs
- Pₙ₋ᵣ: counter output
- CM: control module
- Ct: counter
- Us: signal voltage
- U_{R}: reference voltage
- U_{TH}: threshold voltage
- U_{DD}: supply voltage
- T: converted time interval
- t₁: time instant of detecting the beginning of the converted time interval T
- t₂: time instant of detecting the end of the converted time interval T
- to: time instant of the end of measuring the reference time period
- CI: counter interval
- ST: signal time period
- RT: reference time period
- SRT: initial fragment of the reference time period
- ERT: final fragment of the reference time period

## Claims

1. A method for clockless and direct conversion of a time interval to a digital word, consisting in detecting a beginning and an end of the converted time interval by means of a control module, and mapping the converted time interval in the form of a difference of lengths of a reference time period and of a signal time period, such that the reference time period is measured from a time instant when the beginning of the converted time interval is detected by means of the control module, whereas the signal time period is measured from a time instant when the end of the converted time interval is detected by means of the control module, and the measurement of both time periods is terminated at the same time instant, wherein a precise measurement of a final fragment of the reference time period and of the whole signal time period is implemented by method of weight compensation, in a known way, and the final fragment of the reference time period is composed of quantized, binary scaled reference intervals having known lengths which are measured by charging, by means of a reference current source, capacitors selected from a set of capacitors by means of the control module such that capacitance of each subsequent capacitor in the set of capacitors is twice as low as the capacitance of its immediately preceding capacitor, wherein from the set of capacitors always that capacitor is selected by means of the control module, whose capacitance is currently the highest among capacitors of the set that have not been charged yet, whereas the selected capacitor is charged until reference voltage building up across it, which is compared with threshold voltage by means of a reference comparator, is equal to the threshold voltage, and then a measurement of another reference interval is started by charging another capacitor by means of the reference current source, selected from the set of capacitors by means of the control module, whereas the signal time period is composed of quantized, binary scaled reference intervals having known lengths, which are measured by charging, by means of a signal current source, capacitors selected from the set of capacitors by means of the control module, wherein from the set of capacitors always that capacitor is selected by means of the control module, whose capacitance is currently the highest among capacitors that have not been charged yet, whereas the selected capacitor is charged until reference voltage building up across it, which is compared with threshold voltage by means of a signal comparator, is equal to the threshold voltage, and then a measurement of another reference interval is started by charging another capacitor by means of the signal current source, selected from the set of capacitors by means of the control module, and simultaneously with measuring the final fragment of the reference time period and measuring the whole signal time period the control module assigns, in a known way, corresponding logical values to successive ones from among n-r least significant bits of the output digital word, where n is the number of bits of the output digital word, and r is a linearization degree, wherein to a bit of given index and belonging to n-r least significant bits of the output digital word, a value one is assigned by means of the control module, if during charging a capacitor having the same index and belonging to the set of capacitors by means of the reference current source, charging of the next capacitor by means of the signal current source is not started, or, if during charging a capacitor having the same index and belonging to the set of capacitors by means of the signal current source, charging of the next capacitor by means of the reference current source is started, whereas in other cases a value zero is assigned to this bit by means of the control module, wherein the mentioned actions related to measuring the final fragment of the reference time period, measuring the whole signal time period, and assigning the corresponding logical values to n-r least significant bits of the output digital word are repeated until all capacitors from the set of capacitors are used, and then the measurement of the reference time period and of the signal time period is terminated, **characterized in that** a sum of the lengths of the reference time period (RT) and of the signal time period (ST) is approximately proportional to the length of the converted time interval (T), wherein the length of the reference time period (RT) is first roughly determined by measuring an initial fragment (SRT) of the reference time period (RT) using linear method, and the initial fragment (SRT) of the reference time period (RT) is composed of counter intervals (CI) of identical length which is twice the length of the longest one from the binary scaled reference intervals, and the composing counter intervals (CI) are counted by means of an r-bit counter (Ct), wherein the counter (Ct) is first reset by means of the control module (CM) at the time instant (t₁) when the beginning of the converted time interval (T) is detected by means of the control module (CM), whereas the counter intervals (CI) are measured by charging one counter capacitor (Cₙ₋ᵣ) by means of the reference current source (I_{R}), wherein capacitance of each counter capacitor (Cₙ₋ᵣ) is the same, whereas the counter capacitor (Cₙ₋ᵣ) is charged until reference voltage (U_{R}) building up across it, which is compared with threshold voltage (U_{TH}) by means of the reference comparator (K_{R}), is equal to the threshold voltage (U_{TH}), and then this counter capacitor (Cₙ₋ᵣ) is discharged by means of its assigned counter switch (Sₙ₋ᵣ), by short-circuiting plates of the counter capacitor (Cₙ₋ᵣ), and if no end of the converted time interval (T) is detected during the measurement of this counter interval (CI) by means of the control module (CM), then the content of the counter (Ct) is incremented by means of the control module (CM), and next new content of the counter (Ct) is checked by means of the control module (CM), and if any of bits of this counter has a value zero, then another counter interval (CI) is measured by charging a counter capacitor (Cₙ₋ᵣ) other than before by means of the reference current source (I_{R}) and these actions are repeated until the end of the measurement of the counter interval (CI), during which the end of the converted time interval (T) is detected by means of the control module (CM), or it is checked by means of the control module (CM) that after incrementing the counter (Ct) by means of the control module (CM) new content of the counter (Ct) consists only of bits with a value one, and then, in both cases, to r most significant bits (bₙ₋₁, ..., bₙ₋ᵣ) of the output digital word (B) values of r bits of the counter (Ct) are assigned by means of the control module (CM) and simultaneously a measurement of the final fragment (ERT) of the reference time period (RT) is started in a known way.

2. The method according to claim 1, **characterized in that** the linearization degree r is a natural number greater than one and less than the number n of bits (bₙ₋₁, ..., bₙ₋ᵣ, bₙ₋ᵣ₋₁, ..., b₀) of the output digital word (B).

3. The method according to claim 2, **characterized in that** efficiency of the reference current source (I_{R}) is the same as efficiency of the signal current source (I_{S}) and simultaneously capacitance of each counter capacitor (Cₙ₋ᵣ) is twice as high as capacitance of the capacitor (Cₙ₋ᵣ₋₁) with the highest capacitance in the set of capacitors (CS).

4. The method according to claim 2, **characterized in that** efficiency of the reference current source (I_{R}) is controlled and during measuring the initial fragment (SRT) of the reference time period (RT) it is kept by means of the control module (CM) at a value k-times lower than the efficiency of the signal current source (I_{S}), whereas during measuring the final fragment (ERT) of the reference time period (RT) it is kept by means of the control module (CM) at a value equal to the efficiency of the signal current source (I_{S}) and simultaneously capacitance of each counter capacitor (Cₙ₋ᵣ) is k-times lower than double capacitance of the capacitor (Cₙ₋ᵣ₋₁) with the highest capacitance in the set of capacitors (CS).
